# EUROPÄISCHE PATENTANMELDUNG

(11) **EP 4 733 038 A1**
(43) Veröffentlichungstag der Anmeldung: **29.04.2026**
(21) Anmeldenummer: 25210963.2
(22) Anmeldetag: 24.10.2025
(51) Int. Cl.: B29C 48/09, B29C 48/15, B29C 48/154, B29D 23/00, B29D 29/00, B65G 15/32, F16L 11/12, F16L 11/127, F16L 53/38, G01M 5/00, H05K 1/181, H05B 3/58, F16L 25/01

(54) **MEHRSCHICHTVERBUNDARTIKEL MIT INTEGRIERTER LEITERANORDNUNG**

(30) Priorität: 24.10.2024 DE 102024210288
(71) Anmelder: ContiTech Deutschland GmbH, 30175 Hannover (DE)
(72) Erfinder: Schröder, André, 34346 Hann. Münden (DE); Wolfer, Tim, 30419 Hannover (DE)
(74) Vertreter: Preusser, Andrea

(57) **Zusammenfassung**

Die Erfindung betrifft ein Verfahren (100) zur Herstellung eines Mehrschichtverbundartikels (10) mit einer integrierten Leiteranordnung (20). Es wird vorgeschlagen, auf einer Trägerschicht (12) des Mehrschichtverbundartikels (10), auf der die Leiteranordnung (20) positioniert ist, einen Verdrängungskörper (30) zu positionieren, so dass beim Auftragen der Deckschicht (13) auf die Trägerschicht (12) in einer vorbestimmten Schichtdicke (a) ein auf den Verdrängungskörper (30) aufgetragener Abschnitt der Deckschicht (13) derart dünn ist, dass die Position des Verdrängungskörpers (30) im Mehrschichtverbundartikel haptisch und/oder optisch von außen erkennbar ist.

## Beschreibung

Die vorliegende Erfindung betrifft ein Verfahren zur Herstellung eines Mehrschichtverbundartikels mit einer darin integrierten Leiteranordnung mit den Merkmalen des Anspruchs 1. Gegenstand der Erfindung ist ebenfalls ein Mehrschichtverbundartikel mit den Merkmalen des Anspruchs 8.

Durch die Integration von Leiteranordnungen in Mehrschichtverbundartikel wie Schläuche, Förderbänder, Riemen und/oder Luftfedern lassen sich diverse vorteilhafte Funktionen sensorischer, signalübertragender und/oder aktuatorischer Art realisieren.

Ein Problem hierbei ist die elektrische Kontaktierung der in den Schichtverbund eingebetteten Leiteranordnung zum Zwecke der Signalübertragung und/oder zum Zwecke der Energieversorgung. Hierzu muss eine Außenschicht bzw. Deckschicht des Schichtverbunds durchbrochen und ein Kontaktierungsbereich der Leiteranordnung freigelegt werden, um anschließend mit einer externen Komponente, z.B. mit einem Kabel oder einem Stecker, elektrisch verbunden zu werden. Beim Durchbrechen der Außenschicht und dem Freilegen des Kontaktierungsbereichs ist darauf zu achten, dass weder die Leiteranordnung noch der übrige Mehrschichtverbundartikel beschädigt werden. Überdies ist in vielen Anwendungsfällen die Außenschicht intransparent und relativ fest ausgebildet, so dass die genaue Position der Leiteranordnung weder optisch noch haptisch erkennbar ist.

Aufgabe der vorliegenden Erfindung ist es, ein Verfahren zur Herstellung eines Mehrschichtverbundartikels mit integrierter Leiteranordnung bereitzustellen, welches die Nachteile des Standes der Technik zumindest teilweise vermindert. Insbesondere soll ein Verfahren bereitgestellt werden, das die elektrische Kontaktierung der in den Schichtverbund eingebetteten Leiteranordnung zum Zwecke der Signalübertragung und/oder zum Zwecke der Energieversorgung vereinfacht.

Diese Aufgabe wird durch Verfahren mit den Merkmalen des Anspruchs 1 gelöst. Bevorzugte Merkmale sind Gegenstand der abhängigen Ansprüche. Weitere Vorteile und Merkmale sind der allgemeinen Beschreibung sowie den Ausführungsbeispielen zu entnehmen. Gegenstand der vorliegenden Erfindung ist auch ein Mehrschichtverbundartikel mit den Merkmalen des Anspruchs 8.

Das erfindungsgemäße Verfahren zur Herstellung eines Mehrschichtverbundartikels, insbesondere eines Schlauches und/oder eines Förderbands, enthaltend ein elastomeres Material sowie vorzugsweise einen Festigkeitsträger, mit einer in dem Mehrschichtverbundartikel integrierten Leiteranordnung, weist folgende Schritte auf:
- Bereitstellen einer Trägerschicht des Mehrschichtverbundartikels;
- Anordnen einer Leiteranordnung in einem ersten Bereich auf der Trägerschicht;
- Aufbringen, insbesondere Extrudieren, einer die Trägerschicht und die Leiteranordnung zumindest teilweise bedeckenden Deckschicht in einer vorbestimmten Schichtdicke.

Das erfindungsgemäße Verfahren zeichnet sich durch folgenden Schritt aus:
- Bereitstellen oder Anordnen eines Verdrängungskörpers in dem ersten Bereich auf der Trägerschicht, wobei der Verdrängungskörper eine maximale Dicke aufweist, die zwischen 60 % und 100 % der vorbestimmten Schichtdicke, bevorzugt zwischen 80 % und 100 % der vorbestimmten Schichtdicke der Deckschicht entspricht.

Der Erfindung liegt die Idee zugrunde, die Deckschicht an einer klar definierten Stelle gezielt auszudünnen, um auf diese Weise die Position der Leiteranordnung leichter erkennbar zu machen und das Durchbrechen der Deckschicht zum Zwecke der elektrischen Kontaktierung der Leiteranordnung zu begünstigen. Die Schichtdicke der Deckschicht ist durch die zum Aufbringen der Deckschicht verwendeten Werkzeuge, wie beispielsweise eine Extrusionsdüse oder ein Rakel, gegeben bzw. vorbestimmt. Die vorbestimmte Schichtdicke kann auch als Nominalschichtdicke bzw. Soll-Schichtdicke bezeichnet werden. Die Schichtdicke für die Deckschicht wird dabei insbesondere durch den Abstand von einer Außenfläche der Trägerschicht zu einer Innenfläche des zum Aufbringen der Deckschicht verwendeten Werkzeugs definiert. Bei der Schlauchproduktion ist die Schichtdicke der Deckschicht beispielsweise durch den Außendurchmesser der Trägerschicht und den Innendurchmesser der Extrusionsdüse definiert.

Werden Bauteile oder Strukturen mit einer bestimmten Dicke in einem bestimmten Bereich auf die Trägerschicht aufgebracht, kann die wahre Dicke der Deckschicht in dem Bereich kleiner sein als die vorbestimmte Schichtdicke. Die Leiteranordnung, die beispielsweise auf eine folienartige Substratschicht gedruckt sein kann, weist in der Regel eine weitaus geringere Dicke auf als die Deckschicht (z.B. weniger als 20 % der Schichtdicke der Deckschicht). Daher weicht im Bereich der Leiteranordnung die wahre Dicke der Deckschicht nicht erheblich von der vorbestimmten Dicke ab.

Durch das Bereitstellen oder Anordnen eines Verdrängungskörpers in dem ersten Bereich auf der Trägerschicht, wobei der Verdrängungskörper eine maximale Dicke aufweist, die zwischen 60 % und 100 % der Schichtdicke, bevorzugt zwischen 80 % und 100 % der Schichtdicke der Deckschicht entspricht, wird die wahre Dicke der Deckschicht derart ausgedünnt, dass die Position des Verdrängungskörpers und somit mittelbar oder unmittelbar auch der Leiterbahnanordnung haptisch ertastbar und/oder optisch von außen erkennbar ist. Der Verdrängungskörper kann dabei gemeinsam mit der Leiteranordnung in dem ersten Bereich auf der Trägerschicht angeordnet werden oder separat.

Es kann in einigen Anwendungsfällen, insbesondere beim Extrudieren, auch vorkommen, dass die auf den Verdrängungskörper aufgebrachte Deckschicht durch die Innenfläche des zum Aufbringen der Deckschicht verwendeten Werkzeugs derart abgeschält wird, dass der Verdrängungskörper freiliegt. Auf diese Weise wird ein separater Schritt zum Freilegen des Verdrängungskörpers begünstigt oder im besten Fall obsolet.

Insbesondere weist die Leiteranordnung und optional eine Substratschicht, auf der die Leiteranordnung angeordnet ist, eine Dicke auf, die weniger als 30 %, bevorzugt weniger als 20 %, besonders bevorzugt weniger als 10 % der vorbestimmten Schichtdicke der Deckschicht, entspricht. Vorzugsweise beträgt die Dicke der Leiteranordnung (mit oder ohne Substratschicht) 1 nm bis 500 µm. Besonders bevorzugt beträgt die Dicke des der Leiteranordnung 100 nm bis 50 µm, so dass die Leiteranordnung mittels bewährter Druck-Verfahren prozesssicher hergestellt werden kann. Die Dicke der Leiteranordnung ist hierbei definiert als die quer zur Schichtebene bzw. in radialer Richtung gemessene Abmessung der Leiteranordnung.

Das elastomere Material ist insbesondere ein Elastomer und/oder ein thermoplastisches Elastomer.

Der Mehrschichtverbundartikel ist insbesondere ein Schlauch, dessen Schichten sich im Wesentlichen rotationssymmetrisch um eine Längsmittelachse erstrecken, wobei die Trägerschicht einen Fluidkanal zur Führung eines Fluids umschließt. In diesem Fall kann die Trägerschicht als Innenschicht und/oder die Deckschicht als Außenschicht bezeichnet werden. In diesem Fall bilden die Trägerschicht und die Deckschicht jeweils einen im Wesentlichen zylindrischen Mantel aus. In diesem Fall ist eine Richtung, entlang der Dicken bzw. Höhen gemessen werden, die radiale Richtung bezogen auf die Längsmittelachse.

Die Leiteranordnung kann eine gedruckte Elektronik sein, d.h. die Leiterbahnen können durch leitfähige Tinten auf ein insbesondere flexibles, dielektrisches Substrat ausgebildet sein. Die Funktionen der gedruckten Elektronik können dabei z.B. sensorischer, signalübertragender und/oder aktuatorischer Art sein. In anderen Worten kann die Leiteranordnung einen Sensor, eine Antenne und/oder einen Aktuator oder einen Teil davon ausbilden.

Vorzugsweise beträgt die Dicke der Trägerschicht 0,5 mm bis 50 mm, bevorzugt 1 mm bis 10 mm. Vorzugsweise beträgt die Dicke der Deckschicht 0,5 mm bis 50 mm, bevorzugt 1 mm bis 10 mm.

In einer bevorzugten Ausgestaltung des erfindungsgemäßen Verfahrens sind die Leiteranordnung und der Verdrängungskörper auf einer gemeinsamen Substratschicht angeordnet, insbesondere aufgedruckt. Auf diese Weise können Leiteranordnung und Verdrängungskörper in einfacher Weise gemeinsam in den Mehrschichtverbundartikel eingebracht werden. Zudem ist dadurch eine Relativposition von Leiteranordnung und Verdrängungskörper definiert.

In einer weiteren bevorzugten Ausgestaltung des erfindungsgemäßen Verfahrens ist der Verdrängungskörper aus einem elektrisch leitfähigem Material ausgebildet. Auf diese Weise kann der Verdrängungskörper mittels elektromagnetischer Sensoren lokalisiert werden. Ferner kann der Verdrängungskörper auf diese Weise mit der Leiteranordnung zusammenwirken und beispielsweise selbst die Kontaktierungsmöglichkeit ausbilden. Bevorzugt ist der Verdrängungskörper mit der Leiteranordnung elektrisch leitend verbunden. Vorzugsweise weist der Verdrängungskörper einen Kontaktierungsbereich auf, der dazu ausgebildet ist, mit einer externen Komponente, insbesondere mit einem Stecker und/oder einem Kabel, elektrisch verbunden zu werden. Alternativ kann der Verdrängungskörper eine von der Leiteranordnung separate Struktur sein, die insbesondere von der Leiteranordnung beabstandet und/oder zumindest galvanisch getrennt ist.

In einer weiteren bevorzugten Ausgestaltung des erfindungsgemäßen Verfahrens weist das Verfahren folgende Schritte auf:
- Freilegen zumindest eines Teils des Verdrängungskörpers, insbesondere durch Entfernen eines den Verdrängungsköper bedeckenden Abschnitts der Deckschicht; und/oder
- Elektrisches Kontaktieren des Verdrängungskörpers und/oder der Leiteranordnung mit einer externen Komponente, insbesondere mit einem Kabel oder einem Stecker.

Gemäß dem bereits vor- sowie dem weiter unten nachbeschriebenen wird die eingangs gestellte Aufgabe auch durch ein Verfahren mit den Merkmalen des Anspruchs 8 gelöst.

Der erfindungsgemäße Mehrschichtverbundartikel, insbesondere Schlauch und/oder Förderband, enthält ein elastomeres Material sowie vorzugsweise einen Festigkeitsträger. Der Mehrschichtverbundartikel weist eine Trägerschicht und eine in einem ersten Bereich auf der Trägerschicht angeordnete Leiteranordnung auf. Die Leiteranordnung und die Trägerschicht sind zumindest teilweise von einer Deckschicht des Mehrschichtverbundartikels bedeckt, die in einer vorbestimmten Schichtdicke bzw. Nominalschickdicke auf die Trägerschicht aufgebracht ist. Der Mehrschichtverbundartikel kennzeichnet sich durch einen in dem ersten Bereich auf der Trägerschicht angeordneten Verdrängungskörper aus, der eine maximale Dicke aufweist, die zwischen 60 % und 100 % der vorbestimmten Schichtdicke der Deckschicht, bevorzugt zwischen 80 % und 100 % der Schichtdicke der Deckschicht entspricht.

Auf diese Weise werden die für das Verfahren beschriebenen Vorteile auch in dem Mehrschichtverbundartikel realisiert.

In einer bevorzugten Ausgestaltung des erfindungsgemäßen Mehrschichtverbundartikels sind die Leiteranordnung und der Verdrängungskörper auf einer gemeinsamen Substratschicht angeordnet, insbesondere aufgedruckt.

In einer weiteren bevorzugten Ausgestaltung des erfindungsgemäßen Mehrschichtverbundartikels ist der Verdrängungskörper aus einem elektrisch leitfähigem Material ausgebildet.

In einer weiteren bevorzugten Ausgestaltung des erfindungsgemäßen Mehrschichtverbundartikels ist der Verdrängungskörper mit der Leiteranordnung elektrisch leitend verbunden.

In einer weiteren bevorzugten Ausgestaltung des erfindungsgemäßen Mehrschichtverbundartikels weist der Verdrängungskörper einen Kontaktierungsbereich auf, der dazu ausgebildet ist, mit einer externen Komponente, insbesondere mit einem Stecker und/oder einem Kabel, elektrisch verbunden zu werden.

In einer weiteren bevorzugten Ausgestaltung des erfindungsgemäßen Mehrschichtverbundartikels ist der Verdrängungskörper eine von der Leiteranordnung separate Struktur.

Es wird ausdrücklich darauf hingewiesen, dass die vorstehend erläuterten Ausgestaltungen der Erfindung jeweils für sich oder in einer beliebigen technisch sinnvollen Kombination auch untereinander jeweils mit dem Gegenstand der unabhängigen Ansprüche kombinierbar sind.

Abwandlungen und Ausgestaltungen der Erfindung sowie weitere Vorteile und Einzelheiten der Erfindung lassen sich der nachfolgenden gegenständlichen Beschreibung und den Zeichnungen entnehmen. In den schematischen Figuren zeigen:
- Fig. 1: ein Ausführungsbeispiel eines erfindungsgemäßen Mehrschichtverbundartikels in einer Schnittdarstellung;
- Fig. 2: ein Ablaufschema eines Ausführungsbeispiels eines erfindungsgemäßen Verfahrens.

Gleich oder ähnlich wirkende Teile sind - sofern dienlich - mit identischen Bezugsziffern versehen.

Einzelne technische Merkmale der nachbeschriebenen Ausführungsbeispiele können auch in Kombination mit vorbeschriebenen Ausführungsbeispielen sowie den Merkmalen der unabhängigen Ansprüche und etwaiger weiterer Ansprüche zu erfindungsgemäßen Gegenständen kombiniert werden.

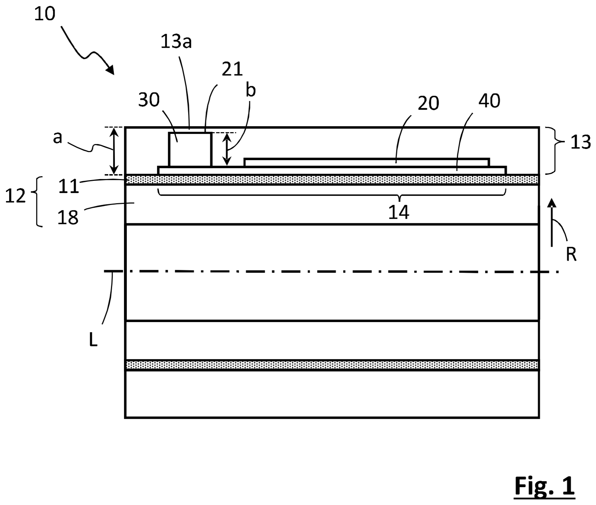

Fig. 1 zeigt ein Ausführungsbeispiel eines erfindungsgemäßen Mehrschichtverbundartikels 10, der eine Trägerschicht 12 und eine in einem ersten Bereich 14 auf der Trägerschicht 12 angeordnete Leiteranordnung 20 aufweist. Der Mehrschichtverbundartikel 10 weist ferner eine auf der Trägerschicht 12 in einer vorbestimmten Schichtdicke a aufgebrachte Deckschicht 13 auf. Die Deckschicht 13 bedeckt hierbei die Leiteranordnung 20. Die Trägerschicht 12 und/oder die Deckschicht 13 enthalten ein Elastomer und/oder ein thermoplastisches Elastomer.

Im vorliegenden Fall ist der Mehrschichtverbundartikel 10 als Schlauch ausgebildet, dessen Schichten 12, 13 sich rotationssymmetrisch um eine Längsmittelachse L erstrecken. Eine Höhe bzw. Dicke einer Schicht oder eines Körpers wird in diesem Fall in radialer Richtung R gemessen. Die Trägerschicht 12 kann in diesem Fall auch als Innenschicht bezeichnet werden. Die Deckschicht 13 kann in diesem Fall auch als Außenschicht bezeichnet werden. Die Trägerschicht 12 weist eine innerste Schicht 18 auf, die einen Fluidkanal definiert. Die Trägerschicht 12 weist ferner einen metallischen oder textilen Festigkeitsträger 11 auf.

Zum Zwecke der Signal- und/oder Energieübertragung muss die Leiteranordnung 20 mit einer externen Komponente, wie einem Kabel oder einem Stecker kontaktiert werden. Hierzu muss die Deckschicht 13 im die Leiteranordnung 20 und/oder eine Substratschicht 40, auf der die Leiteranordnung 20 angeordnet ist, überdeckenden ersten Bereich 14 durchbrochen werden. Die Leiteranordnung 20 und die Substratschicht 40, auf der die Leiteranordnung 20 angeordnet oder aufgedruckt ist, weisen gemeinsam beispielsweise eine Dicke von 100 µm auf, was in vielen Anwendungsfällen gleich oder weniger als 10 % der vorbestimmten Schichtdicke a der Deckschicht 13 von 1 mm bis 10 mm entspricht. Wenn die Deckschicht 13 beispielsweise als schwarze Gummischicht ausgebildet ist, kann die Position der Leiteranordnung 20 in dem Mehrschichtverbundartikel 10 von außen weder durch Ertasten noch mit dem bloßen Auge erkannt werden.

Eine Lokalisierung der Leiteranordnung 20 und ein Durchbruch der Deckschicht 13 werden dadurch begünstigt, dass in dem ersten Bereich 14 auf der Trägerschicht 12 ein Verdrängungskörper 30 angeordnet ist, der eine maximale Dicke b aufweist, die zwischen 60 % und 100 % der vorbestimmten Schichtdicke a der Deckschicht 13, bevorzugt zwischen 80 % und 100 % der vorbestimmten Schichtdicke a der Deckschicht 13 entspricht. Der über dem Verdrängungskörper 30 befindliche Abschnitt 13a der Deckschicht 13 weist eine gegenüber der vorbestimmten Schichtdicke a viel kleinere Schichtdicke auf, so dass der Verdrängungskörper 30 von außen haptisch oder optisch erkannt werden kann. Somit kann auch die Position der Leiteranordnung 20 leichter ermittelt werden.

Die Leiteranordnung 20 und der Verdrängungskörper 30 sind auf einer gemeinsamen Substratschicht 40 angeordnet, insbesondere aufgedruckt, so dass sie während der Herstellung gemeinsam auf der Trägerschicht 12 angeordnet werden können.

Im vorliegenden Fall ist der Verdrängungskörper 30 eine von der Leiteranordnung 20 separate Struktur. Alternativ kann der Verdrängungskörper 30 aus einem elektrisch leitfähigem Material ausgebildet und mit der der Leiteranordnung 20 elektrisch leitend verbunden sein. Der Verdrängungskörper 30 kann ferner einen Kontaktierungsbereich 21 aufweisen, der dazu ausgebildet ist, mit einer externen Komponente, insbesondere mit einem Stecker und/oder einem Kabel, elektrisch verbunden zu werden.

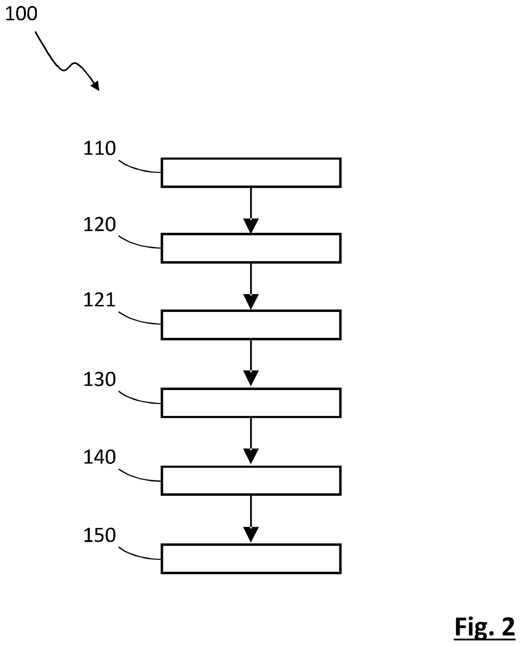

Fig. 2 zeigt ein Ablaufschema eines Ausführungsbeispiels eines erfindungsgemäßen Verfahrens 100 zur Herstellung eines Mehrschichtverbundartikels 10, insbesondere eines Schlauches und/oder eines Förderbands, enthaltend ein elastomeres Material sowie vorzugsweise einen Festigkeitsträger, mit einer in dem Mehrschichtverbundartikel 10 integrierten Leiteranordnung 20, wobei das Verfahren 100 folgende Schritte aufweist:
- Bereitstellen 110 einer Trägerschicht 12 des Mehrschichtverbundartikels 10;
- Anordnen 120 einer Leiteranordnung 20 in einem ersten Bereich 14 auf der Trägerschicht 12;
- Anordnen 121 eines Verdrängungskörpers 30 in dem ersten Bereich 14 auf der Trägerschicht 12, wobei der Verdrängungskörper 30 eine maximale Dicke b aufweist, die zwischen 60 % und 100 % der vorbestimmten Schichtdicke a der Deckschicht 13, bevorzugt zwischen 80 % und 100 % der Schichtdicke a der Deckschicht 13 entspricht; und
- Aufbringen 130, insbesondere Extrudieren, einer die Trägerschicht 12 und die Leiteranordnung 20 zumindest teilweise bedeckenden Deckschicht 13 in einer vorbestimmten Schichtdicke a.

Ersichtlich können die Schritte 120 und 121 in umgekehrter Reihenfolge oder gemeinsam ausgeführt werden.

Optional weist das Verfahren 100 folgenden Schritt auf:
- Freilegen 140 zumindest eines Teils des Verdrängungskörpers 30 durch Entfernen der eines den Verdrängungskörper 30 bedeckenden Abschnitts 13a der Deckschicht 13.

Optional weist das Verfahren 100 folgenden Schritt auf:
- Elektrisches Kontaktieren 150 des Verdrängungskörpers 30 mit einer externen Komponente, insbesondere mit einem Kabel oder einem Stecker.

Ergänzend sei darauf hingewiesen, dass "aufweisend" keine anderen Elemente oder Schritte ausschließt und "ein" oder "eine" keine Vielzahl ausschließt.

Der Schutzbereich der vorliegenden Erfindung ist durch die Patentansprüche gegeben und wird durch die in der Beschreibung erläuterten oder den Figuren gezeigten Merkmale nicht beschränkt.

## Patentansprüche

1. Verfahren (100) zur Herstellung eines Mehrschichtverbundartikels (10), insbesondere nach einem der Ansprüche 8 bis 13, insbesondere eines Schlauches und/oder eines Förderbands, enthaltend ein elastomeres Material sowie vorzugsweise einen Festigkeitsträger, mit einer in dem Mehrschichtverbundartikel (10) integrierten Leiteranordnung (20), aufweisend folgende Schritte:
- Bereitstellen (110) einer Trägerschicht (12) des Mehrschichtverbundartikels (10);
- Anordnen (120) einer Leiteranordnung (20) in einem ersten Bereich (14) auf der Trägerschicht (12);
- Aufbringen (130), insbesondere Extrudieren, einer die Trägerschicht (12) und die Leiteranordnung (20) zumindest teilweise bedeckenden Deckschicht (13) in einer vorbestimmten Schichtdicke (a);
**gekennzeichnet durch**
- Bereitstellen oder Anordnen eines Verdrängungskörpers (30) in dem ersten Bereich (14) auf der Trägerschicht (12), wobei der Verdrängungskörper (30) eine maximale Dicke (b) aufweist, die zwischen 60 % und 100 % der vorbestimmten Schichtdicke (a) der Deckschicht (13) entspricht.

2. Verfahren (100) nach Anspruch 1, wobei die Leiteranordnung (20) und der Verdrängungskörper (30) auf einer gemeinsamen Substratschicht (40) angeordnet, insbesondere aufgedruckt sind.

3. Verfahren (100) nach Anspruch 1 oder 2, wobei der Verdrängungskörper (30) aus einem elektrisch leitfähigem Material ausgebildet ist.

4. Verfahren (100) nach Anspruch 3, wobei der Verdrängungskörper (30) mit der Leiteranordnung (20) elektrisch leitend verbunden ist.

5. Verfahren (100) nach Anspruch 4, wobei der Verdrängungskörper (30) einen Kontaktierungsbereich (21) aufweist, der dazu ausgebildet ist, mit einer externen Komponente, insbesondere mit einem Stecker und/oder einem Kabel, elektrisch verbunden zu werden.

6. Verfahren (100) nach einem der Ansprüche 1 bis 3, wobei der Verdrängungskörper (30) eine von der Leiteranordnung (20) separate Struktur ist.

7. Verfahren (100) nach einem der vorangehenden Ansprüche, aufweisend folgende Schritte:
- Freilegen (140) zumindest eines Teils des Verdrängungskörpers (30); und/oder
- Elektrisches Kontaktieren (150) des Verdrängungskörpers (30) und/oder der Leiteranordnung (20) mit einer externen Komponente, insbesondere mit einem Kabel oder einem Stecker.

8. Mehrschichtverbundartikel (10), insbesondere Schlauch und/oder Förderband, enthaltend ein elastomeres Material sowie vorzugsweise einen Festigkeitsträger, mit einer in dem Mehrschichtverbundartikel (10) integrierten Leiteranordnung (20),
wobei der Mehrschichtverbundartikel eine Trägerschicht (12), eine in einem ersten Bereich (14) auf der Trägerschicht (12) angeordnete Leiteranordnung (20) und eine die Leiteranordnung (20) zumindest teilweise bedeckende, und in einer vorbestimmten Schichtdicke (a) aufgebrachte Deckschicht (13) aufweist,
**gekennzeichnet durch**
einen in dem ersten Bereich (14) auf der Trägerschicht (12) angeordneten Verdrängungskörper (30), der eine maximale Dicke (b) aufweist, die zwischen 60 % und 100 % der vorbestimmten Schichtdicke (a) der Deckschicht (13) entspricht.

9. Mehrschichtverbundartikel (10) nach Anspruch 8, wobei die Leiteranordnung (20) und der Verdrängungskörper (30) auf einer gemeinsamen Substratschicht (40) angeordnet, insbesondere aufgedruckt sind.

10. Mehrschichtverbundartikel (10) nach Anspruch 8 oder 9, wobei der Verdrängungskörper (30) aus einem elektrisch leitfähigem Material ausgebildet ist.

11. Mehrschichtverbundartikel (10) nach Anspruch 10, wobei der Verdrängungskörper (30) mit der Leiteranordnung (20) elektrisch leitend verbunden ist.

12. Mehrschichtverbundartikel (10) nach Anspruch 11, wobei der Verdrängungskörper (30) einen Kontaktierungsbereich (21) aufweist, der dazu ausgebildet ist, mit einer externen Komponente, insbesondere mit einem Stecker und/oder einem Kabel, elektrisch verbunden zu werden.

13. Mehrschichtverbundartikel (10) nach einem der Ansprüche 8 bis 10, wobei der Verdrängungskörper (30) eine von der Leiteranordnung (20) separate Struktur ist.
